# EUROPEAN PATENT SPECIFICATION

(11) **EP 3 196 720 B1**
(45) Date of publication and mention of the grant of the patent: **29.01.2020**
(21) Application number: 16198151.9
(22) Date of filing: 10.11.2016
(51) Int. Cl.: G05B 19/402, B64C 1/26, G05B 19/418, G05B 19/42, G01B 11/00

(54) **METHODS AND SYSTEMS FOR WING-TO-BODY JOINING**
VERFAHREN UND SYSTEME ZUR FLÜGEL-RUMPF-VERBINDUNG
PROCÉDÉS ET SYSTÈMES DE JONCTION AILE-FUSELAGE

(30) Priority: 22.01.2016 US 201615004808
(43) Date of publication of application: 26.07.2017
(73) Proprietor: The Boeing Company, Chicago, IL 60606-1596 (US)
(72) Inventor: Bode, Aksel, Chicago, IL 60606-1596 (US); Bui, Peter Hoang, Chicago, IL 60606-1596 (US); Cooke, Barry Theophile, Chicago, IL 60606-1596 (US); Leander, Joseph Alan, Chicago, IL 60606-1596 (US); Dinh, Ngan Minh, Chicago, IL 60606-1596 (US); Koopman, Paul Alan, Chicago, IL 60606-1596 (US); Puzey, Kevin Ronald, Chicago, IL 60606-1596 (US)
(74) Representative: Witte, Weller & Partner Patentanwälte mbB

(56) References cited:
- EP-A1- 2 368 799
- EP-A1- 2 939 786
- EP-A2- 0 957 336
- US-A1- 2005 172 470

## Description

### FIELD

The present disclosure relates to automated assembly systems and methods.

### BACKGROUND

Aircraft assembly includes fitting together many complex and often large components in precise relationships. For example, wings and tail planes (e.g., vertical stabilizer, horizontal stabilizer) may be assembled substantially whole and then attached to the corresponding section of the aircraft body. As another example, the fuselage of an aircraft may be the combination of several body assemblies where each body assembly is a barrel section of the fuselage. Some components, including some very large components such as the wings, fuselage sections, and tail assemblies, are designed to be assembled with high accuracy, e.g., with relative positional tolerances between parts of less than 0.05 inch (in.) (about 1 millimeter (mm)).

To achieve the desired relative fit with the appropriate accuracy, the positions of the components normally are inspected at points leading to the final fit position. For example, when fitting a wing assembly to the corresponding body assembly of an aircraft, the wing assembly may be sequentially moved to locations and the relative positions of the wing and body assemblies inspected to determine whether the assemblies have contacted each other. The inspection may be visual when the assemblies are sufficiently separated. When the assemblies approach the final position, inspection may require using manual or electronic feeler gauges around the mating interfaces to determine sufficient clearance. Such processes may be very tedious and time consuming to achieve the exacting tolerances required of critical components.

Shims are used extensively in the aircraft industry to fit and join together large components. Shims, also called fillers, are used to fill gaps (or voids) between joined parts. Gaps may be designed gaps that are designed to allow for manufacturing tolerance, alignment of components, and proper aerodynamic assembly of the aircraft. The use of shims to fill gaps between mating parts results in more accurately assembled and more structurally sound aircraft.

Shims typically are custom sized for the gaps that are formed between the parts. Measuring, preparing, and installing the shims may be a very time consuming and tedious process. In some circumstances, some shims may be pre-formed according to the expected gaps, in a process called predictive shimming. If the actual gap formed by the joined parts is not the same as the expected gap (e.g., if the parts are not placed accurately), the pre-formed shim would need to be modified or replaced in a manner similar to manual shimming.

EP 0 957 336 A2 is entitled system and method for aligning coordinate systems for assembling an aircraft.

EP 2 368 799 A1 is entitled method for fitting part assemblies.

US 2005/0172470 A1 is entitled methods and systems for large-scale airframe assembly.

### SUMMARY

Disclosed wing-to-body join methods include commanding a wing assembly of an aircraft to a first command position and then iteratively repeating a first-phase movement. The first-phase movement includes determining a first-phase position of the wing assembly by automatically measuring three dimensional locations of a plurality of wing targets on the wing assembly, calculating a first-phase difference between the first-phase position and the first command position, and commanding the wing assembly to reduce the magnitude of the first-phase difference. The iteratively repeating the first-phase movement is performed until the magnitude of the first-phase difference is less than or equal to a first-phase error tolerance. Such methods further include commanding the wing assembly to a second command position and then iteratively repeating a second-phase movement. The second-phase movement includes determining a second-phase position of the wing assembly by automatically measuring three dimensional locations of the plurality of wing targets on the wing assembly, determining a second-phase position of the body assembly by automatically measuring three dimensional locations of a plurality of body targets on the body assembly, calculating a second-phase relative position based on a difference between the second-phase position of the wing assembly and the second-phase position of the body assembly, calculating a second-phase difference between the second-phase relative position and the second-phase command relative position, and commanding the wing assembly to reduce the magnitude of the second-phase difference. The iteratively repeating the second-phase movement is performed until the magnitude of the second-phase difference is less than or equal to a second-phase error tolerance. The method further includes: calculating a virtual fit between a wing assembly and a body assembly of the aircraft; and measuring a 3D profile of a wing root interface surface of the wing assembly, measuring a 3D profile of a wing stub interface surface of the body assembly, and wherein the calculating the virtual fit includes calculating the virtual fit based upon the 3D profile of the wing root interface surface and the 3D profile of the wing stub interface surface; wherein the mated position is defined by the virtual fit, and wherein the movement path is based upon actual as-built shapes of the wing assembly and body assembly, wherein the actual shapes are modeled by performing a 3D scan based on the 3D profile of the wing root interface surface (22) and the 3D profile of the wing stub interface surface. Some embodiments include performing the second-phase steps (e.g., commanding to the second command position and then iteratively repeating the second-phase movement) without performing the first-phase steps. Some embodiments include performing a port-side move for a port wing assembly of the aircraft and performing a starboard-side move for a starboard wing assembly of the aircraft.

### BRIEF DESCRIPTION OF THE DRAWINGS

Fig. 1 is a schematic representation of wing-to-body join methods according to the present disclosure.
Fig. 2 is a schematic representation of first-phase movement methods.
Fig. 3 is a schematic representation of second-phase movement methods.
Fig. 4 is a schematic representation of methods of determining target reference locations.
Fig. 5 illustrates an example of a wing-to-body join system with wings separated from the aircraft before assembly.
Fig. 6 illustrates a wing and body in an initial position, from a perspective to show wing stub details.
Fig. 7 illustrates the wing and body in the initial position of Fig. 6, from a perspective to show wing root details.
Fig. 8 illustrates a body assembly with examples of primary body target locations and secondary body target locations.
Fig. 9 illustrates a wing root with examples of primary wing target locations.
Fig. 10 illustrates a wing assembly with examples of secondary wing target locations.
Fig. 11 illustrates the wing and body of Figs. 6-7 in an intermediate position.
Fig. 12 illustrates the wing and body of Figs. 6-7 in a final position with the wing mated to the body.
Fig. 13 schematically represents a cross section of a wing root and a wing stub joined with shims.

### DESCRIPTION

Wing-to-body join methods and systems according to the present disclosure permit quicker and more certain assembly of the wing to the body of an aircraft and assembly of other large structures. Methods include measuring the 3D (three-dimensional) location of optical targets at the interfaces to be joined (e.g., the wing root and wing stub of an aircraft) and using these locations to track the positions of the wing and body. The locations of the optical targets on the as-built interfaces may be determined by scanning the interfaces to produce surface profiles of the interfaces to identify the optical target locations. The wing may be moved to the body in at least two phases with a series of waypoints. In the first phase, the wing and body are sufficiently far apart to avoid likely contact between the components. The position of the wing at each waypoint is determined by measuring the targets on the wing. Errors in the actual position versus the desired position are corrected by moving the wing in a feedback loop. In the second phase, the wing is sufficiently close to the body that the potential for contact exists. For each waypoint, the relative position of the wing and body is determined by measuring the targets on the wing and the body. Errors in the actual relative position versus the desired relative position are corrected by moving the wing relative to the body in a feedback loop.

The disclosed feedback process with a series of waypoints permits accurate movement of the wing to the body (moving the large structure(s) through a precise movement path) and accurate placement of the wing with respect to the body for final assembly of the wing to the body. The accuracy of the movement and/or the placement may be achieved even when utilizing a positioning system that has a lesser accuracy. Because of the high accuracy through a series of waypoints, the need for manual inspection of the wing-body system as the wing is mated to the body for final assembly may be reduced or essentially eliminated, thus reducing assembly time. Additionally or alternatively, the high accuracy may permit more accurate and/or extensive predictive shimming.

Though examples in this disclosure may refer to aircraft and/or aircraft components, the systems and methods of this disclosure may be utilized with other structures and other components. For example, systems and methods of the present disclosure may be utilized with vehicles, machinery, and large structures. The systems and methods may be associated with automotive assembly, ship building, spacecraft assembly, and/or building construction.

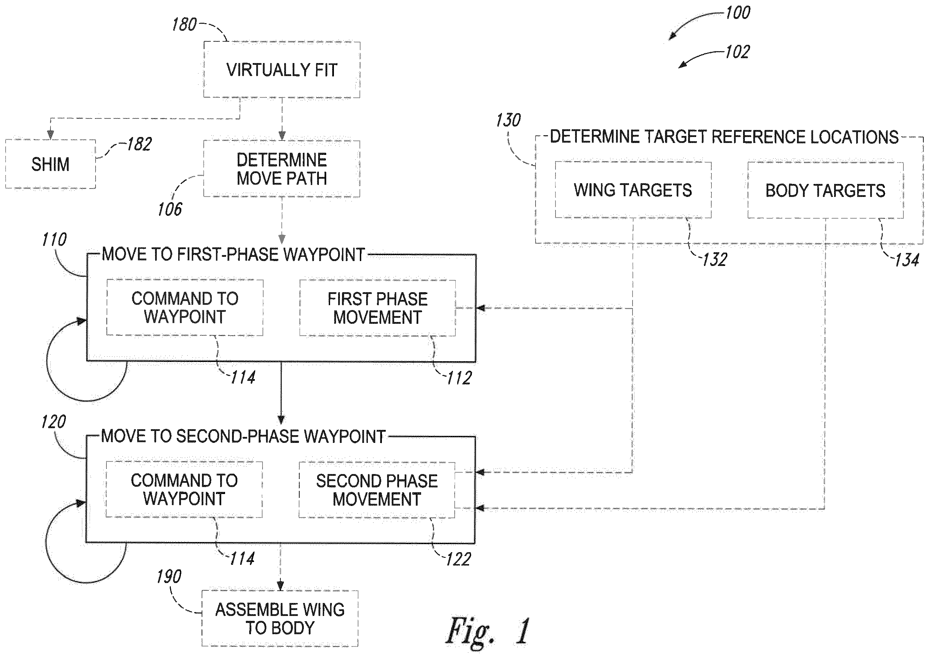

Figs. 1-13 illustrate wing-to-body join methods and systems. In general, in the drawings, elements that are likely to be included in a given embodiment are illustrated in solid lines, while elements that are optional or alternatives are illustrated in dashed lines. However, elements that are illustrated in solid lines are not essential to all embodiments of the present disclosure, and an element shown in solid lines may be omitted from a particular embodiment without departing from the scope of the present disclosure. Elements that serve a similar, or at least substantially similar, purpose are labelled with numbers consistent among the figures. Like numbers in each of the figures, and the corresponding elements, may not be discussed in detail herein with reference to each of the figures. Similarly, all elements may not be labelled or shown in each of the figures, but reference numerals associated therewith may be used for consistency. Elements, components, and/or features that are discussed with reference to one or more of the figures may be included in and/or used with any of the figures without departing from the scope of the present disclosure.

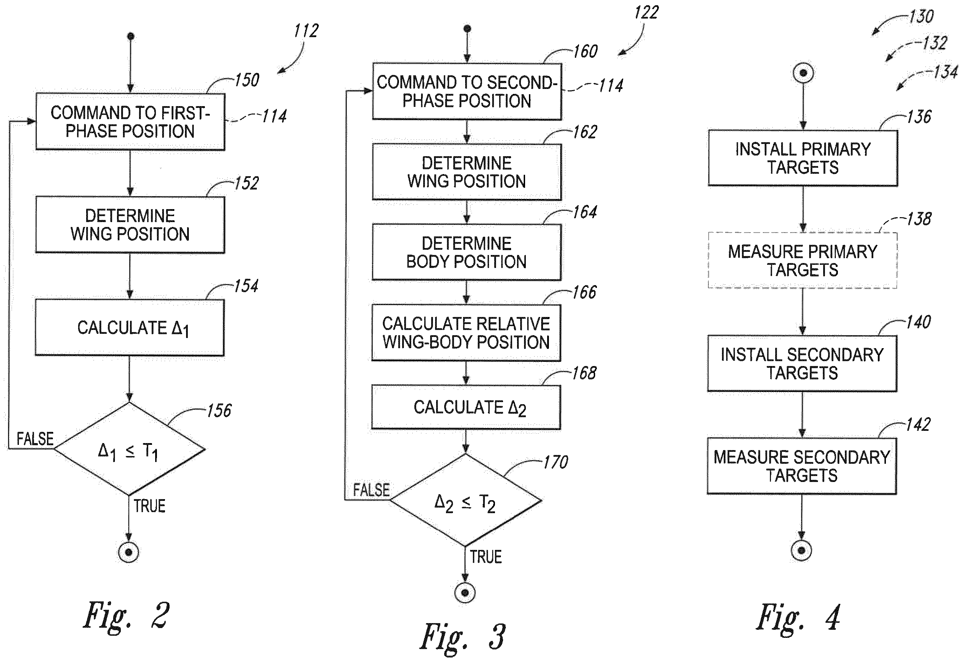

Fig. 1 is a schematic representation of wing-to-body joining methods 100. Methods 100 may include moving 110 the wing to at least one first-phase waypoint (position of the wing) and then moving 120 the wing to at least one second-phase waypoint (relative position of the wing and body). With respect to the first and second phases, methods 100 may include one or both of the phases. For example, methods 100 may include moving 110 to the first-phase waypoint(s), moving 120 to the second-phase waypoint(s), or moving 110 to the first-phase waypoint(s) and then moving 120 to the second-phase waypoint(s). Methods 100 may include determining 130 target reference locations of optical targets on the wing and/or body. Figs. 2-4 detail various aspects of methods 100.

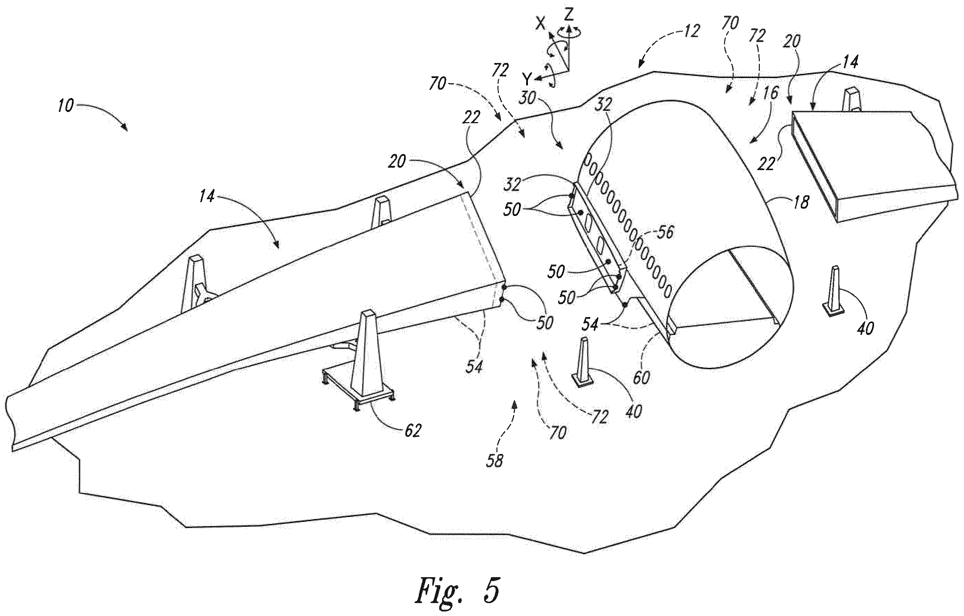

Fig. 5 is a representation of a wing-to-body join system 10 for an aircraft 12. The wing-to-body join system 10 may be configured, adapted, and/or programmed to perform one or more steps of methods 100 and/or may be utilized with methods 100. The system 10 is configured to align and to assemble a wing 14 to a body 16 (e.g., to a fuselage section 18 of the body 16) of the aircraft 12. The wing 14 (which may be referred to as a wing assembly) may be a complete, substantially complete, and/or partially complete aircraft wing. As illustrated in Fig. 5, aircraft 12 typically have two or more wings 14. The body 16 (which may be referred to as a body assembly) may be a complete, substantially complete, and/or partially complete aircraft body and/or fuselage section.

Methods 100 may be applicable to joining one wing 14, both wings 14 (e.g., port and starboard wings), and/or all wings 14. When joining more than one wing 14, the wings 14 may be joined to the body 16 sequentially, at least partially concurrently, and/or concurrently.

The wing 14 mates to the body 16 at a wing root 20 (of the wing 14) and a wing stub 30 (of the body 16). The wing root 20 and the wing stub 30 are the wing joint interfaces of the wing 14 and the body 16, respectively. The wing root 20 also may be referred to as the wing box. The wing stub 30 also may be referred to as the side body box. The body 16 may include one wing stub 30 for each wing 14 of the aircraft 12. For example, the body 16 may include a port-side wing stub 30 to mate to the wing root 20 of a port wing 14 and a starboard-side wing stub 30 to mate to the wing root 20 of a starboard wing 14.

As used herein, references to directions and rotations use the terminology of the aircraft industry. The coordinate system for the aircraft 12 is indicated in Fig. 5, with the x-axis indicating the fore-aft direction, the y-axis indicating the port-starboard direction, and the z-axis indicating the up-down direction. The x, y, and z coordinates with respect to the aircraft 12 also may be called the station (or fuselage station), the butt line, and the water line, respectively. Each structure may be located in three dimensions and have a three dimensional rotational orientation. Together the location and orientation may be referred to as the position. Thus, the position may describe the three dimensional aspect of a structure, including three degrees of translational location and three degrees of rotational orientation. With respect to the aircraft 12, rotation about the x-axis is referred to as roll; rotation about the y-axis is referred to as pitch; and rotation about the z-axis is referred to as yaw. The position of each structure may be specified with respect to local coordinates, relative to the structure rather than the aircraft 12. For example, each wing 14 may have an orientation specified with respect to local coordinates with an origin at the wing root-wing stub interface. The orientation of the wing 14 with respect to the body 16 may be referred to as the dihedral angle (rotation about a local axis parallel to the x-axis), the incidence angle (rotation about a local axis parallel to the y-axis, also called the wing pitch), and the sweep angle (rotation about a local axis parallel to the z-axis, also called the wing rake).

Each of the wing root 20 and the wing stub 30 have interface structures such as flanges, panels, fittings, frames, spars, ridges, grooves, pins, holes, etc. that are configured to mate together. The interface structures mate with the corresponding structures of the opposite wing root 20 or wing stub 30. The surfaces that mate together are wing root interface surfaces 22 (of the wing root 20) and wing stub interface surfaces 32 (of the wing stub 30). Generally, the wing 14 fits to the body 16 like a plug and socket, with interface surfaces on both of the wing root 20 and the wing stub 30 facing various directions (e.g., up, down, fore, aft, inboard, and/or outboard). For example, the interface surfaces of an interface plate extending from the wing root 20 may include an upward-facing surface and a downward-facing surface. The mating structures of the wing stub 30 may include corresponding downward-facing surfaces and upward-facing surfaces. Mating interface surfaces do not necessarily contact each other when mated. Interface surfaces may define a gap when mated. Generally, the wing root interface surfaces 22 and the wing stub interface surfaces 32 are configured to mate in a high-precision alignment. Hence, any contact, if present, may be a close fit (e.g., an interference fit or a slip fit) and any gap, if present, may be small (e.g., a span of less than 5 mm (about 0.2 in.), less than 1 mm (about 0.04 in.), less than 0.2 mm (about 0.008 in.), or less than 0.1 mm (about 0.004 in.)). As discussed herein, gaps, in particular gaps with a span greater than a predefined threshold thickness, may be filled by shims.

The wing root 20 and the wing stub 30 may be relatively large structures and have relatively large cross sectional areas (as measured in a hypothetical plane that separates the joint). The wing root 20 and the wing stub 30 may have substantially the same cross sectional dimensions. The span of the wing root 20 and the wing stub 30 (each independently) in the x-direction may be greater than 1 m (meter) (about 3 ft. (feet)), greater than 2 m (about 7 ft.), greater than 4 m (about 13 ft.), less than 20 m (about 66 ft.), and/or less than 10 m (about 33 ft.). The span of the wing root 20 and the wing stub 30 (each independently) in the y-direction may be greater than 0.3 m (about 1 ft.), greater than 0.6 m (about 2 ft.), greater than 1 m (about 3 ft.), less than 10 m (about 33 ft.), and/or less than 5 m (about 16 ft.). The wing root 20 and the wing stub 30 each independently may have a cross sectional area (in the plane of the joint) of greater than 1 m² (square meters) (about 10 sq. ft. (square feet)), greater than 2 m² (about 20 sq. ft.), greater than 10 m² (about 100 sq. ft.), greater than 20 m² (about 200 sq. ft.), less than 100 m² (about 1,000 sq. ft.), and/or less than 20 m² (about 200 sq. ft.).

Though the examples herein focus on joining the wing to the body of an aircraft, systems and methods of the present disclosure are applicable to the alignment and assembly of other large and/or complex components such as, for aircraft, joining tail planes to a tail assembly and/or fuselage, and joining fuselage sections together. Therefore, references to wings and aircraft bodies may be substituted with references to a first mating structure (or part assembly) and a second mating structure (or part assembly). The mating structures have interfaces (corresponding to the wing root 20 and the wing stub 30) and interface surfaces at the interfaces (corresponding to the wing root interface surfaces 22 and the wing stub interface surfaces 32). The systems and methods of the present disclosure may be applied to the mating structures to join the interfaces together in a precise alignment of the respective interface surfaces.

During alignment and assembly, the wing 14 may be supported and/or positioned by one or more wing positioners 62, and the body 16 may be supported and/or positioned by one or more body positioners 60. Each wing 14 may be supported and/or positioned by an independent group of one or more wing positioners 62. Wing positioners 62 and body positioners 60 also may be referred to as wing join tools and body join tools, respectively. Wing positioners 62 and body positioners 60 may be configured to manipulate the position (i.e., orientation and/or location) of the respective wing 14 and body 16. The group of wing positioners 62 for a wing 14 and the body positioners 60 may be referred to as a wing positioning system 58. The system 10 may include a wing positioning system 58 for each wing 14 (optionally sharing the body positioners 60 for each wing positioning system 58) and/or may include a wing positioning system 58 for all wings 14. Generally, the wing positioners 62 and body positioners 60 of the wing positioning system 58 are configured to move the wing 14 relative to the body 16 with at least six degrees of freedom (three translational and three rotational). The degrees of freedom may be split between the wing positioners 62 and the body positioners 60. Additionally or alternatively, the wing positioners 62 and the body positioners 60 may be capable of the same type of motion (e.g., both capable of moving the respective wing 14 and body 16 in the x-direction). Generally, the wing positioners 62 as a group are configured to move the respective wing 14 relative to the body 16 with at least four degrees of freedom, three rotational degrees and one translational degree along the y-axis (port-starboard, inboard-outboard direction). For example, in Fig. 5, the port wing 14 is supported by one wing positioner 62 configured to move the port wing 14 relative to the body 16 with six degrees of freedom (three translational and three rotational).

Wing positioners 62 and/or body positioners 60 may include jacks, actuators, lift devices, motors, wheels, treads, and/or locomotion devices. Wing positioners 62 and/or body positioners 60 may be powered by internal or external sources via, for example, electricity, hydraulic pressure, and/or pneumatic pressure. Wing positioners 62 and/or body positioners 60 may be self-propelled and/or may be described as vehicles. Wing positioners 62, body positioners 60, and/or wing positioning systems 58 may include an electronic controller and may be referred to as robotic and/or computer-controlled positioners and/or systems. Wing positioners 62, body positioners 60, and/or wing positioning systems 58 may be ultimately operated by a human operator (e.g., with a remote control) and/or may operate autonomously and/or semi-autonomously (e.g., following the alignment and/or positioning methods described herein).

Returning generally to Fig. 1 (with respect to methods) and Fig. 5 (with respect to structures), moving 110 to the first-phase waypoint(s) and moving 120 to the second-phase waypoint(s) include determining the position of the wing 14 and may include determining the position of the body 16. The positions of the wing 14 and body 16 may be determined with optical targets installed on the respective wing 14 and body 16. Optical targets generally are optically distinct objects and may include (and/or may be) a reflector, a retroreflector, a symbol, and/or a marking that is optically distinct (e.g., that stands apart from the nearby optical background). Optical targets may include reflective materials, absorptive materials, fluorescent materials, and/or luminescent materials. Optical targets may be referred to as retroreflective targets, reflective targets, coded targets (e.g., including barcodes, 2D (two dimensional) barcodes, alphanumeric characters, and/or other symbols), fluorescent targets, and/or luminescent targets. Optical targets may be adapted for photogrammetry, laser tracking, or other optical techniques. For example, optical targets may respond to illumination light and/or ambient light (e.g., by reflecting, absorbing, scattering, and/or fluorescing). Optical targets also may be referred to as targets, photogrammetry targets, and/or laser-tracking targets.

In Fig. 5, the optical targets are indicated as primary targets 50 and secondary targets 54. Primary targets 50 are optical targets located on or in the wing root 20 or the wing stub 30. Because the primary targets 50 are on or in the wing root 20 or the wing stub 30, optical access to the primary targets 50 may be obscured as the wing 14 and body 16 are brought together to join the wing 14 to the body 16. Secondary targets 54 are optical targets associated with the wing 14 or the body 16, and the corresponding primary targets 50. The secondary targets 54 are located to permit optical access during the wing join process, at least during the portion of the process in which the primary targets 50 are obscured, not present, or otherwise unavailable.

The primary targets 50 are in locations that are known with respect to the corresponding wing root interface surfaces 22 and the wing stub interface surfaces 32. For example, the primary targets 50 may be installed at predetermined locations such as fiducial points or reference points used during the design and/or construction of the corresponding wing root 20 and wing stub 30. Additionally or alternatively, the locations of one or more of the primary targets 50 may be determined by measuring (e.g., optically and/or automatically) the 3D location of the target relative to the associated wing root 20, wing stub 30, or corresponding surfaces. The surface geometry of the wing root interface surfaces 22 and/or the wing stub interface surfaces 32 may be known from design models (as-designed shapes) and/or from surface models derived from surface scanning (as-built shapes). The 3D locations of the targets on the corresponding interface surface may be measured with a laser tracker, a laser range finder, a LIDAR system, and/or a photogrammetric system. The 3D locations of the targets may be determined by scanning the primary targets 50 with the corresponding interface surface(s).

The primary targets 50 generally are dispersed about the wing root 20 and the wing stub 30. Dispersing (as opposed to clustering) the primary targets 50 about the corresponding interface may provide for more measurement position options (e.g., more positions in which a threshold number of primary targets 50 are visible) and/or a better 3D representation of the position of the corresponding wing root 20 or wing stub 30. Generally, each of the wing root 20 and the wing stub 30 may have 2, 3, 4, 5, 6, or more primary targets 50.

The secondary targets 54 are in locations that are known with respect to the primary targets 50 (i.e., one or more of the primary targets 50) of the corresponding wing root 20 or wing stub 30. The locations of the secondary targets 54 may be measured with respect to the primary targets 50 and/or may be in predetermined relationships with the primary targets 50. For example, the location of one or more of the secondary targets 54 may be determined by measuring the 3D location of the secondary target 54 relative to one or more of the associated primary targets 50. The 3D location may be measured with a 3D measurement system 40 (e.g., a laser tracker, a laser range finder, a LIDAR system, and/or a photogrammetric system). One or more secondary targets 54 may be located in predetermined relationships with the primary targets 50, e.g., if the secondary target 54 and primary target 50 are affixed on a frame together and the frame with the targets is installed on the respective wing 14 or body 16.

The secondary targets 54 generally are dispersed about the wing 14 near the wing root 20 and the body 16 near the wing stub 30. Dispersing (as opposed to clustering) the secondary targets 54 about the corresponding region may provide for more measurement position options (e.g., more positions in which a threshold number of secondary targets 54 are visible) and/or a better 3D representation of the position of the corresponding wing 14 or body 16. Generally, each of the wing 14 and the body 16 may have 2, 3, 4, 5, 6, or more secondary targets 54.

Methods 100 generally include moving one or more wings 14 to the body 16 in a two-phase process with a series of waypoints. The movement path of the wing 14 is a 3D path that translates and/or rotates the wing 14 from an initial position to a final position in which the wing 14 is mated to the body 16. The movement path follows a series of waypoints (intermediate positions) configured to transfer the wing 14 to its final position without significant contact between the wing 14 and body 16. Each waypoint is a position of the wing 14 relative to the body 16 or at least relative to a fixed coordinate system related to the body 16. In some embodiments, the movement path is configured to avoid contact between the parts at all waypoints, at least until the mating engagement associated with the final position. The initial position, which may be referred to as the separated position, and the final position, which may be referred to as the mated position, may each independently be waypoints.

As shown in Fig. 1, methods 100 may include determining 106 the movement path to move the wing 14 and body 16 together into a mating arrangement. The movement path is configured to move the wing 14 and body 16 into alignment and to place the wing 14 and body 16 in the mating arrangement of the final position. In part because of the complexity of the wing root interface surfaces 22, the complexity of the wing stub interface surfaces 32, and the desired accuracy, the movement path for wings 14 to bodies 16 typically involves more than simple linear movement in one direction. For example, the movement path may include segments of rotation, segments of translation, segments of coupled rotation (e.g., rotation about more than one axis), segments of coupled translation (e.g., translation along more than one axis), and/or segments of coupled translation and rotation. With respect to the movement path, a segment is a portion of the movement path between two waypoints. A segment of the movement path may include one or more waypoints.

Determining 106 the movement path may include calculating a movement path based upon the as-designed nominal shapes of the wing 14 and the body 16. Additionally or alternatively, determining 106 the movement path may be based upon the actual, as-built shapes of the wing 14 and body 16. The actual shapes are modeled (e.g., by performing a 3D scan as discussed with respect to the interface surfaces and virtually fitting) and may include deviations of the individual parts from the engineering design. In some embodiments, a preliminary movement path is determined based upon nominal part shapes and then modified according to the actual, measured part shapes to produce the movement path. Each waypoint of the movement path may be independently moved from the corresponding waypoint of the preliminary movement path. Such movements may be simple translations but, more commonly, the movements may include translations and rotations that may result in a new path shape and/or different part orientations.

The final mating position of the wing 14 and body 16 is determined by a virtual fit. For example, methods 100 include virtually fitting 180 of the wing 14 to body 16 to establish a virtual fit. Virtually fitting 180 includes utilizing virtual models (as-designed and/or as-built models) of the wing root 20 and the wing stub 30 and aligning the virtual models in a virtual fit. The virtual fit may be based upon engineering design, the parts as-designed and/or as-built, and/or aerodynamic considerations. The as-designed models of the parts may be referred to as the engineering models and may be in the form of a CAD (computer-aided design) model or other 3D representation. The as-built models may be CAD models or other 3D representations derived from 3D surface scans of the surfaces that will mate (e.g., the wing root interface surfaces 22 and the wing stub interface surfaces 32). For example, the wing root interface surfaces 22 and/or the wing stub interface surfaces 32 are scanned (e.g., with 3D surface scanning) to determine the actual, as-built shapes of the surfaces (also referred to as surface profiles). The surface scan is utilized to create a virtual model of the as-built surfaces, which can be referred to as a 3D profile of the surface. Scanning the parts rather than relying on the engineering models of the parts permits the virtual fit to account for real-world, as-built deviation of the parts from the designed shapes.

The virtual fit is configured to place the wing 14 in the designed aerodynamic position and achieve gaps between the wing root 20 and the wing stub 30 of less than a threshold thickness. The final, mated position is the virtual fit position determined by the virtually fitting 180.

Virtually fitting 180 includes identifying gaps between the wing root 20 and the wing stub 30. Further, virtually fitting 180 is used to define and/or create shims to fill the gaps, indicated as shimming 182 in Fig. 1. Shimming 182, also called predictive shimming 182, may include determining shim dimensions to substantially fill one or more of the gaps, forming shims according to the determined shim dimensions, and/or installing shims in the corresponding real gaps that are formed by the real fit achieved by the moving 110 to the first-phase waypoint(s) and/or the moving 120 to the second-phase waypoint(s). Shimming 182 may be performed before ever bringing the wing 14 and body 16 together (e.g., the shims formed before beginning moving 110 and/or moving 120). The resulting shims may be installed on the wing root 20 and/or wing stub 30 before beginning moving 110 and/or moving 120.

Methods 100 may be configured to incrementally move the wing 14 along the movement path, one waypoint at a time. For example, moving 110 to the first-phase waypoint(s) and/or moving 120 to the second-phase waypoint(s). By incrementally moving, deviations in the actual movement/positions of the wing 14 and/or body 16 may be identified and/or corrected during the overall movement before the deviations become compounded. Movement deviations may be due to, e.g., deflection of the parts, flexing of the parts, inaccuracy of the wing positioning system 58 (Fig. 5), and/or imprecision of the wing positioning system 58.

The waypoints between the initial position and the final mating position may be unequally spaced and generally are spaced apart in a decreasing series, with the waypoints of the first phase generally separated by greater distances than the waypoints in the second phase. For example, the minimum spacing between sequential waypoints of the first phase (optionally all of the spacings of the first phase) may be larger than the minimum spacing between sequential waypoints of the second phase (optionally all of the spacing of the second phase). Waypoints are generally configured further apart when the distance between the wing 14 and the body 16 is greater and/or when the accuracy requirement of relative placement is lower. Hence, the waypoints nearer the initial position of the movement path and/or the waypoints of the first phase may correspond to rough or coarse movement, and the waypoints nearer the final mating position of the movement path and/or the waypoints of the second phase may correspond to fine movement. For example, the spacing between sequential waypoints in the first phase (e.g., the first two waypoints) may be less than 500 mm (about 20 in.), less than 200 mm (about 8 in.), less than 100 mm (about 4 in.), less than 50 mm (about 2 in.), greater than 10 mm (about 0.4 in.), greater than 20 mm (about 0.8 in.), and/or greater than 50 mm (about 2 in.). The spacing between sequential waypoints in the second phase (e.g., the last two waypoints) may be less than 50 mm (about 2 in.), less than 10 mm (about 0.4 in.), less than 5 mm (about 0.2 in.), less than 2 mm (about 0.08 in.), greater than 0.1 mm (about 0.004 in.), greater than 0.5 mm (about 0.02 in.), and/or greater than 1 mm (about 0.04 in.).

In the first phase of the movement process, methods 100 include moving to one or more waypoints along the path. As shown in Fig. 1, moving 110 to the first-phase waypoint may include performing 112 a first-phase movement or commanding 114 the wing 14 to the selected waypoint. Moving 110 may be repeated for each waypoint in the first phase (where the relative position of the wing 14 and body 16 are separated enough that collisions are not likely). For at least one of the waypoints of the first phase, moving 110 includes performing 112 the first-phase movement. Commanding 114 includes commanding the wing positioning system 58 (e.g., the wing positioner(s) 62 and/or the body positioner(s) 60) to move the wing 14 to the selected waypoint.

Fig. 2 details the first-phase movement process. Performing 112 the first-phase movement includes commanding 150 the wing 14 to a command position. Generally, the command position is the waypoint. However, the command position may be a position selected, calculated, and/or estimated to move the wing 14 in the desired direction and/or to the desired position (e.g., the waypoint). Where the commanding 150 is merely commanding the wing positioning system 58 to move the wing 14 to the selected waypoint, commanding 150 is the same as commanding 114.

Performing 112 the first-phase movement includes determining 152 the wing position (e.g., the position of the wing root 20) by measuring the 3D locations of one or more optical targets (e.g., primary targets 50 and/or secondary targets 54). Measuring the 3D locations of the one or more optical targets is measuring in a non-contact manner (e.g., optically), e.g., with the 3D measurement system 40. Measuring the 3D locations generally is an automated process such as machine vision, 3D optical scanning, and/or photogrammetry.

Machine vision is a technique that uses electronic imaging and algorithms to extract geometric information (e.g., position and/or surface shape) from one or more images of the object under study (e.g., the primary targets 50 and/or secondary targets 54 associated with the respective wing root 20 or wing stub 30). For example, machine vision may be used to determine the positions of the primary targets 50. As another example, machine vision may be used to determine the surface shapes of the as-built wing root interface surfaces 22. 3D optical scanning (which includes techniques such as laser tracking, LIDAR, and laser range finding) is a technique which uses light reflection, often from a laser, to calculate the surface geometry of the object under study. Typically, the surface geometry is calculated from the time-of-flight or from triangulation. Additionally or alternatively, 3D optical scanning may be used to measure 3D positions of objects and therefore the relative location of an object on a surface. Photogrammetry is a technique that determines the surface geometry of the object under study through analysis of electronic images, commonly multiple images from different perspectives (angles). Photogrammetry may use multiple cameras to obtain the images from different perspectives. Additionally or alternatively, photogrammetry may be used to measure 3D positions of objects and therefore the relative location of an object on a surface.

Performing 112 includes calculating 154 a first-phase difference (denoted as Δ₁ in Fig. 2) between the wing's actual position (as determined by determining 152) and the command position. Performing 112 further includes iteratively repeating 156 the commanding 150, determining 152, and calculating 154 until the magnitude of the first-phase difference is less than or equal to a first-phase error tolerance (denoted T₁ in Fig. 2). Thus, performing 112 the first-phase movement includes performing the group of commanding 150, determining 152, and calculating 154 one or more times until the first-phase difference is sufficiently small. The commanding 150, determining 152, calculating 154, and repeating 156 form a feedback loop for the positioning of the wing 14.

The first commanding 150 in the repeat loop of the first phase may be commanding the wing positioning system 58 to move the wing 14 to the desired waypoint (the command position). Subsequent commanding 150 in the repeat loop (i.e., commanding 150 events that occur after determining that the first-phase difference is greater than the first-phase error tolerance) may be commanding the wing positioning system 58 to move the wing 14 according to the first-phase difference. For example, subsequent commanding 150 events may include commanding to reduce the magnitude of the first-phase difference and/or commanding the wing positioning system 58 to perform a relative move selected, calculated, and/or estimated to move the wing 14 in a direction to reduce the magnitude of the first-phase difference and/or in a direction toward the desired waypoint.

Returning to Fig. 1, the second phase of movement follows the first phase (if performed), i.e., moving 120 to one or more second-phase waypoint is performed after completing all of the moving 110 to the first-phase waypoint(s). Moving 120 to the second-phase waypoint may include performing 122 a second-phase movement or commanding 114 the wing 20 to the selected waypoint. Moving 120 may be repeated for each waypoint in the second phase (where the relative position of the wing 14 and body 16 are close enough that interference or contact is possible). For at least one of the waypoints of the second phase, moving 120 includes performing 122 the second-phase movement. The transition from the first-phase (e.g., moving 110) to the second-phase (e.g., moving 120) may be based upon a threshold distance between the wing 14 and the body 16, a threshold distance between waypoints, an actual (measured) distance between the wing 14 and the body 16 (e.g., concurrent with moving 110), a difference between the wing 14 position and a waypoint (e.g., a first-phase difference), and/or a predetermined waypoint.

Fig. 3 details the second-phase movement process. Performing 122 the second-phase movement includes commanding 160 the wing 14 to a command position. The command position in the second phase is a position selected to place the wing 14 and the body 16 in a known relative position, referred to as the command relative position. Generally, the command position is the waypoint and the command relative position is the waypoint relative to the body 16. However, the command position may be a position selected, calculated, and/or estimated to move the wing 14 in the desired direction and/or to the desired position (e.g., the waypoint). Where the commanding 160 is merely commanding the wing positioning system 58 to move the wing 14 and body 16 to the selected waypoint, commanding 160 is the same as commanding 114.

Performing 122 the second-phase movement includes determining 162 the wing position (e.g., the position of the wing root 20) by measuring the 3D locations of one or more optical targets (e.g., primary targets 50 and/or secondary targets 54) positioned on the wing 14. At least at the end of the second-phase movement (near the final mating position), the primary targets 50 may be obscured and/or inaccessible, and therefore may not be used at that point. Performing 122 includes determining 164 the body position (e.g., the position of the wing stub 30) by measuring the 3D locations of one or more optical targets (e.g., primary targets 50 and/or secondary targets 54) positioned on the body 16. The measuring associated with the determining 162 the wing position and the determining 164 the body position may be performed as described with respect to the determining 152 the wing position for the first phase. The optical targets of the respective structure (the wing 14 or body 16) are measured in a non-contact manner (e.g., optically), in a generally automatic process such as machine vision, 3D optical scanning, and/or photogrammetry.

Performing 122 includes calculating 166 the second-phase relative position of the wing 14 and body 16 (e.g., the relative position of the wing root 20 and the wing body 30). The second-phase relative position may be based on a difference between the wing position and the body position as determined by the respective determining 162 and determining 164. Performing 122 includes calculating 168 a second-phase difference (denoted as Δ₂ in Fig. 3) between the wing's actual relative position (as calculated by the calculating 166) and the command relative position. Performing 122 further includes iteratively repeating 170 the commanding 160, determining 162, determining 164, calculating 166, and calculating 168 until the magnitude of the second-phase difference is less than or equal to a second-phase error tolerance (denoted T₂ in Fig. 3). Thus, performing 122 the second-phase movement includes performing the group of commanding 160, determining 162, determining 164, calculating 166, and calculating 168 one or more times until the second-phase difference is sufficiently small. The second-phase error tolerance T₂ may be larger, smaller, or equal to the first-phase error tolerance T₁, but generally the second-phase error tolerance T₂ is less than or equal to the first-phase error tolerance T₁, representing an equal or higher precision movement and positioning in the second phase as compared to the first phase. Additionally or alternatively, the spacing between waypoints (generally less in the second phase) may facilitate higher precision movement and positioning in the second phase as compared to the first phase. The commanding 160, determining 162, determining 164, calculating 166, calculating 168, and repeating 170 form a feedback loop for the relative positioning of the wing 14.

The first commanding 160 in the repeat loop of the second phase may be commanding the wing positioning system 58 to move the wing 14 to the desired waypoint (the command position and the command relative position). Subsequent commanding 160 in the repeat loop (i.e., commanding 160 events that occur after determining that the second-phase difference is greater than the second-phase error tolerance) may be commanding the wing positioning system 58 to move the wing 14 according to the second-phase difference. For example, subsequent commanding 160 events may include commanding to reduce the magnitude of the second-phase difference and/or commanding the wing positioning system 58 to perform a relative move selected, calculated, and/or estimated to move the wing 14 in a direction to reduce the magnitude of the second-phase difference and/or in a direction toward the desired waypoint.

During the moving 120 to the second-phase waypoint(s) and/or during performing 122 the second-phase movement, methods 100 may include determining if contact between the wing 14 and body 16 has occurred and/or performing corrective action if contact has occurred. For example, one or more of the positioners of the wing positioning system 58 may include a load sensor configured to indicate the weight and/or other forces supported by the respective positioner. If the wing 14 and body 16 contact, the force of the contact may be sensed by the load sensor(s) and/or the weight of the wing 14 and the body 16 may be redistributed among the positioners of the wing positioning system 58. Additionally or alternatively, a lack or insufficiency of progress when performing 122 the second phase movement (i.e., commanding 160 to the second-phase position does not result in a sufficient reduction in the magnitude of the second-phase difference) may indicate that the wing 14 and body 16 are in contact. The check for contact (e.g., a check for the expected load force) may be performed within the repeating 170 loop, before, during, and/or after the commanding 160 to the second-phase position. If the check indicates that the wing 14 and body 16 have come into contact, the next corresponding move may be a move to overcome the contact (e.g., driving the wing 14 in a direction to achieve the next waypoint) and/or a move to avoid the current or past contact (e.g., backing away from the position where contact occurred).

Fig. 4 illustrates details of determining 130 target reference locations for various structures such as determining 132 wing target reference locations for wing targets on a wing 14 and determining 134 body target reference locations for body targets on a body 16. Determining 130 target reference locations may be utilized to determine the position of the corresponding structure (e.g., determining 152 the first-phase wing position, determining 162 the second-phase wing position, and/or determining 164 the second-phase body position). The position of the structure may be defined and/or modeled by the locations of the targets of the structure. The surface shape of the structure may be as-designed (e.g., known from 3D design models such as CAD models) and/or may be as-built (e.g., determined by scanning the surface).

Determining 130 target reference locations includes installing 136 primary targets on the corresponding structure. Installing 136 may include placing the primary targets 50 on or in the interface of the structure (e.g., the wing root 20 or the wing stub 30). The primary targets 50 may be attached, affixed, adhered, and/or coupled to the interface of the structure. Installing 136 may include installing the primary targets 50 in known locations with respect to the interface of the structure. The locations may be known because they are predetermined locations (e.g., at fiducial points or reference points used during the design and/or construction of the structure) and/or the locations may be known by measuring the locations relative to the structure, surfaces, or predetermined locations (e.g., fiducial points or reference points). Each location of primary targets 50 independently may be a predetermined location and/or a measured location.

Determining 130 may include measuring 138 the primary target locations. Measuring 138 may provide and/or confirm the known locations of the primary targets 50 relative to the corresponding structure, surface, and/or associated predetermined locations (e.g., fiducial points or reference points). Measuring 138 includes measuring the 3D locations of the primary targets 50 in a non-contact manner (e.g., optically). Measuring 138 generally is an automated process such as machine vision, 3D optical scanning, and/or photogrammetry. Measuring 138 generally is performed while the wing positioning system 58 is supporting the corresponding structure (wing 14 and/or body 16). Measuring 138 may include and/or may be performed in conjunction with scanning the corresponding interface surfaces (wing root interface surfaces 22 or wing stub interface surfaces 32) to determine the as-built 3D surface shapes of the interface surfaces.

Measuring 138 may include establishing and/or determining a common coordinate system for the corresponding structure. The common coordinate system may be used to describe the position of the structure and/or may be used to measure features (e.g., secondary targets 54) with respect to the structure. Thus, features such as secondary targets 54 may be measured in the common coordinate system to relate the locations of the features to the primary targets 50 and/or to the structure even if the primary targets 50 are not present or not visible when measuring the features. The common coordinate system may be common to the body 16 and/or one or more of the wings 14.

Determining 130 target reference locations includes installing 140 secondary targets on the corresponding structure. Installing 140 may include placing the secondary targets 54 on the corresponding structure near the interface of the structure such that the secondary targets 54 will be visible during positioning (e.g., moving 110 to the first-phase waypoint(s) and/or moving 120 to the second-phase waypoint(s)). For example, the installing 140 corresponding to determining 132 wing target reference locations may include placing the secondary targets 54 on the wing 14 near the wing root 20. The secondary targets 54 may be attached, affixed, adhered, and/or coupled to the structure (wing 14 or body 16). Installing 140 may include installing the secondary targets 54 in known locations with respect to the primary targets 50. For example, one of the secondary targets 54 may be installed at a location which is a known, predefined, and/or measured distance from at least one of the primary targets 54. As another example, one of the secondary targets 54 may be installed and then measured with respect to the location of at least one of the primary targets 50. As yet another example, at least one of the secondary targets 54 and at least one of the primary targets 50 may be installed as a unit together (e.g., the secondary target(s) 54 and the primary target(s) 50 are on a frame with a known, predefined, and/or measured distance between them).

Determining 130 may include measuring 142 the secondary target locations. Measuring 142 may provide and/or confirm the locations of the secondary targets 54 relative to the primary targets 50 and therefore relative to the corresponding structure, surface, and/or associated predetermined locations (e.g., fiducial points or reference points) of the primary targets 50. By relating the secondary targets 54 to the primary targets 50, the secondary targets 54 may be utilized to determine the position of the corresponding structure. For example, the position of the structure may be defined and/or modeled by the locations of the secondary targets 54. Measuring 142 includes measuring the 3D locations of the secondary targets 54 in a non-contact manner (e.g., optically). Measuring 142 generally is an automated process such as machine vision, 3D optical scanning, and/or photogrammetry. Measuring 142 generally is performed while the wing positioning system 58 is supporting the corresponding structure (wing 14 and/or body 16).

Measuring 142 may include measuring one or more secondary targets 54 with one or more primary targets 50 to measure the relative locations of the secondary targets 54 (relative to the primary targets 50). Measuring 142 may include measuring one or more secondary targets 54 in a common coordinate system determined, established, and/or defined by the known locations of the primary targets 50. Hence, measuring 142 does not require measuring the secondary targets 54 in the presence of the primary targets 50 or with both of the selected secondary target 54 and primary target 50 visible.

Determining 130 target reference locations may include removing one or more of the primary targets 50, after measuring 142 the secondary target locations or after establishing and/or determining a common coordinate system in which to measure the relative locations of the secondary targets 54. That is, one or more of the primary targets 50 may be removed after they are no longer needed to determine the secondary target locations and/or after they are no longer needed to facilitate the first-phase movement and/or the second-phase movement. One or more primary targets 50 may be removed prior to the first-phase movement and/or prior to the second-phase movement. During the second-phase movement process, at least near the final mating position, the primary targets 50 may be obscured and/or inaccessible. Removal of the primary targets 50 may reduce excess parts on the final assembly of the aircraft, may facilitate mating of the wing 14 and body 16, and/or may permit reuse of the primary targets 50 on another structure.

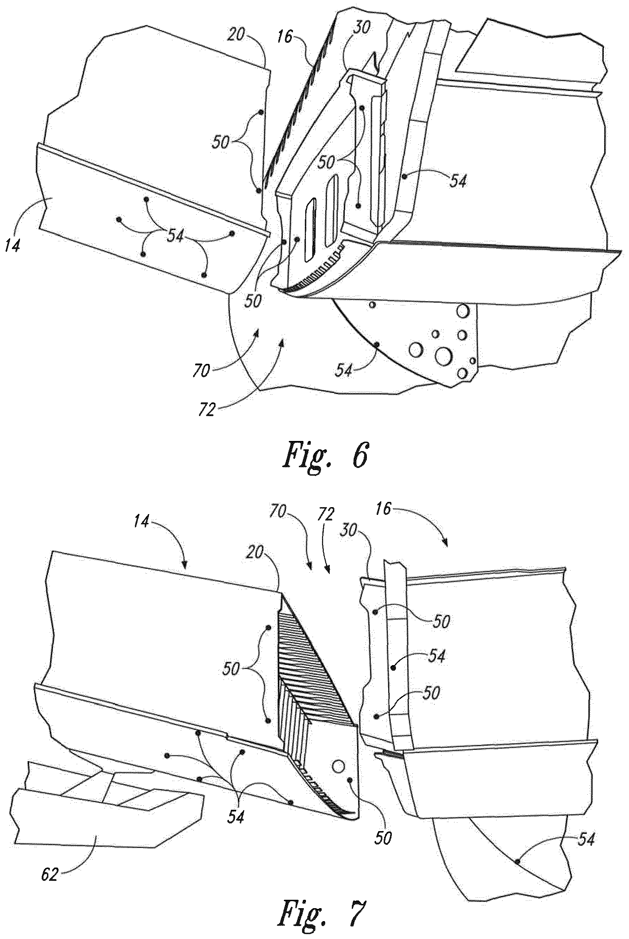

Fig. 6 illustrates an example initial position 72 or a waypoint 70 in the first phase. In the position illustrated in Fig. 6, the wing 14 is sufficiently far from the body 16 that contact between the structures due to small movements is unlikely. For example, the distance between the wing root 20 and the wing stub 30 in the y-direction (inboard-outboard) may be greater than 50 mm (about 2 in.), greater than 100 mm (about 4 in.), greater than 200 mm (about 8 in.), or greater than 500 mm (about 20 in.).

The detail of Fig. 6 also shows some example locations of primary targets 50 and secondary targets 54 on the wing 14 and body 16. The primary targets 50 are on or in the respective wing root 20 or wing stub 30. At least some of the primary targets 50 will be covered by the overlap of the wing root 20 and wing stub 30 as the wing 14 and body 16 are mated. The secondary targets 54 are located outside of the respective wing root interface surfaces 22 and wing stub interface surfaces 32, and may be located outside of the respective wing root 20 and wing stub 30. As the wing 14 and body 16 are mated, the secondary targets 54 will remain visible to facilitate measurement of the positions of the wing 14 and/or body 16 as the wing 14 and body 16 are mated (travelling along the movement path). Fig. 7 illustrates the system of Fig. 6 from a perspective that permits observation of some of the interior of the wing root 20.

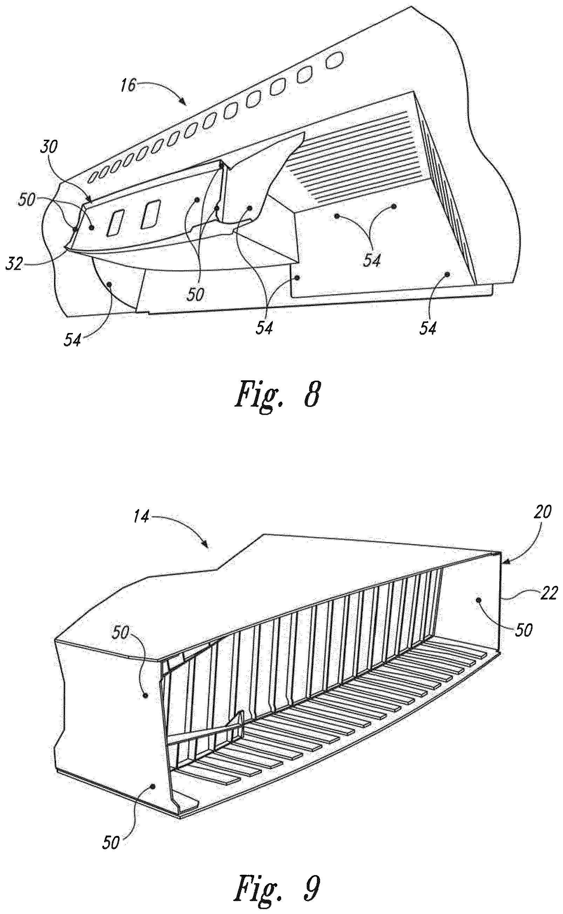

Fig. 8 illustrates further example locations of primary targets 50 and secondary targets 54 on the body 16. In Fig. 8, two primary targets 50 are located on the bulkhead of the interior of the wing stub 30 and three primary targets 50 are located along the edge of the wing stub 30. The secondary targets 54 are located on structures of the body 16 near the wing stub 30.

Each of the secondary targets 54 independently may be above, below, fore, aft, inboard, and/or outboard of the wing stub 30.

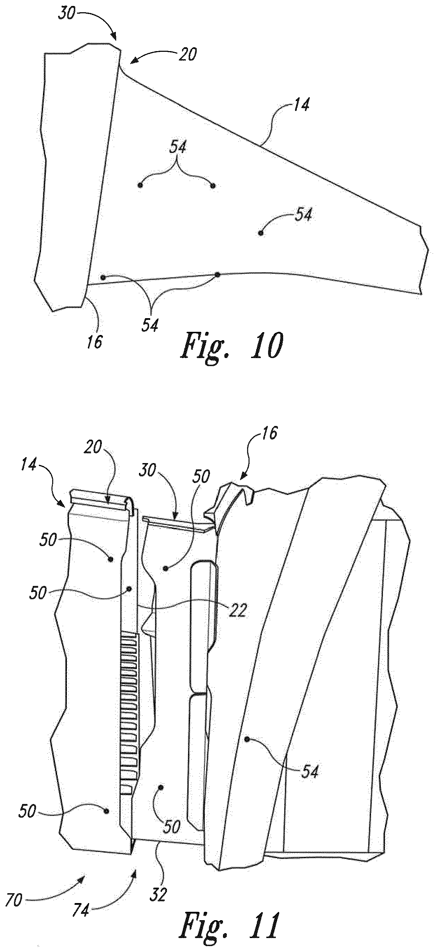

Fig. 9 illustrates further example locations of primary targets 50 on the wing 14. In Fig. 9, three primary targets 50 are located along the edge of the wing root 20. Fig. 10 illustrates further example locations of secondary targets 54 on the wing 14. In Fig. 10, the secondary targets 54 are located on the exterior skin of the wing 14 on the underside of the wing 14. Each of the secondary targets 54 independently may be above, below, fore, aft, inboard, and/or outboard of the wing root 20.

Fig. 11 illustrates a waypoint 70 that is an intermediate position 74. In the intermediate position 74 shown in Fig. 11, the wing 14 and the body 16 are near or at the point when contact between the wing 14 and body 16 are possible due to small movements and/or small deviations from the given position. For example, the distance between the wing root 20 and the wing stub 30 (e.g., the minimum distance between the wing root interface surface 22 and the wing stub interface surface 32) in the y-direction (inboard-outboard) may be greater than 5 mm (about 0.2 in.), greater than 10 mm (about 0.4 in.), greater than 20 mm (about 0.8 in.), greater than 50 mm (about 2 in.), less than 200 mm (about 8 in.), less than 100 mm (about 4 in.), and/or less than 50 mm (about 2 in.).

The intermediate position 74 may represent a transition waypoint between the first phase and the second phase of movement (i.e., the intermediate position 74 of Fig. 11 may be the final waypoint of the moving 110 to the first-phase waypoints and/or may be the initial waypoint of the moving 120 to the second-phase waypoints). In Fig. 11, some of the primary targets 50 of the wing root 20 and the wing stub 30 are visible and some are obscured. The associated secondary targets 54 generally are visible (only one secondary target 54 shown in Fig. 11).

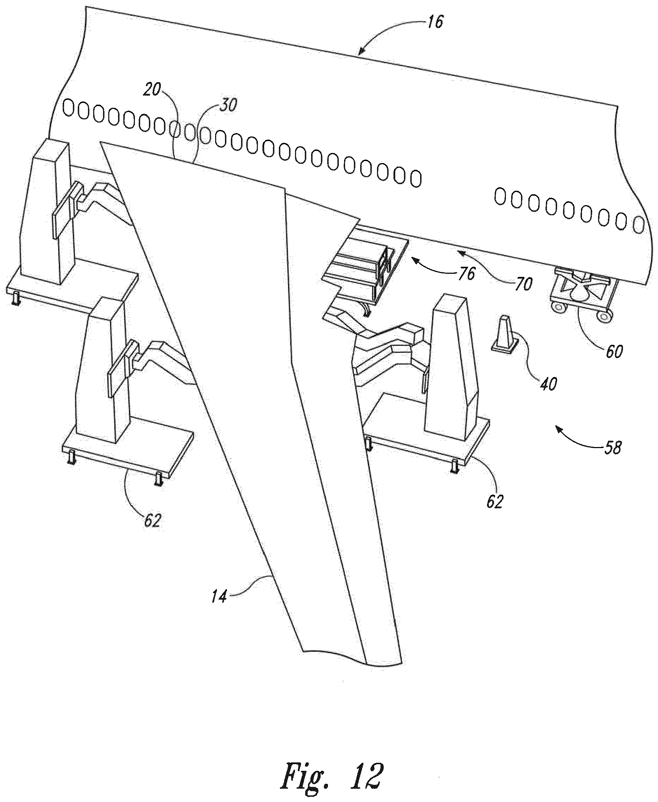

Fig. 12 illustrates a waypoint 70 that is a final position 76. The waypoints associated with the second phase of movement may include the final position 76. Fig. 12 illustrates an example final position 76 in the second phase. In the position illustrated in Fig. 12, the wing 14 is mated to the body 16, and generally in contact with the body 16, optionally via shims. Any unshimmed gaps between the wing 14 and the body 16 in the final position 76 (i.e., gaps between the wing root interface surfaces 22 and the wing stub interface surfaces 32 not filled with a shim or gaps between the shim and the associated interface surface) may be very small. For example, gaps may span a distance less than 1 mm (about 0.04 in.), less than 0.5 mm (about 0.02 in.), less than 0.2 mm (about 0.008 in.), or less than 0.1 mm (about 0.004 in.).

Returning to the general methods 100 shown in Fig. 1, methods 100 may include finishing steps after achieving the final position 76 within the tolerance (e.g., within the second-phase error tolerance) such as assembling 190 the wing 14 to the body 16 and/or removing primary targets 50 and/or secondary targets 54. Assembling 190 may include installing shims between the wing root 20 and the wing stub 30 and/or may include fastening the wing 14 and body 16 together.

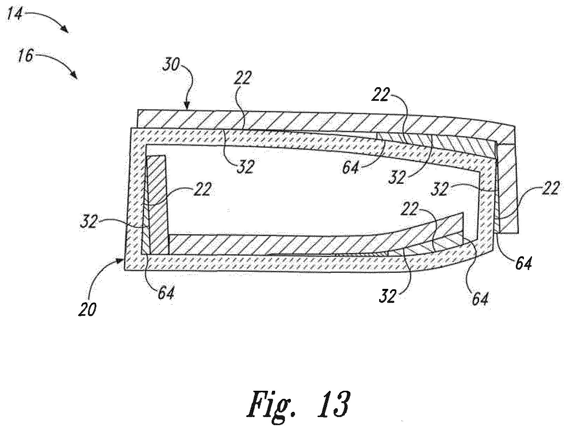

Fig. 13 illustrates shims 64 fit between wing root interface surfaces 22 and wing stub interface surfaces 32. Fig. 13 shows, in cross section, the wing root 20 and wing stub 30 fit together with gaps between the interface surfaces of the wing root 20 and wing stub 30. The relative alignment of the wing 14 and the body 16 may affect the presence, location, and/or size of the gaps. In Fig. 13, shims 64 are present in some of the gaps, substantially filling the gaps between the wing root interface surfaces 22 and the wing stub interface surfaces 32. Shims 64 may fix the alignment of the wing 14 and the body 16, and/or may increase the structural integrity of the wing joint.Shims 64 may be substantially prismatic with a thickness corresponding to the span of the gap. Shims 64 may be contoured to fit the gap, substantially conforming to the local interface surfaces. The thickness of a shim 64 (and the span of a gap) may not be uniform and may vary across a dimension perpendicular to the thickness (and span). Hence, gaps and shims 64 may be wedge-shaped, sheet-like, and/or parallelepiped-shaped.

As used herein, the terms "adapted" and "configured" mean that the element, component, or other subject matter is designed and/or intended to perform a given function. Thus, the use of the terms "adapted" and "configured" should not be construed to mean that a given element, component, or other subject matter is simply "capable of" performing a given function but that the element, component, and/or other subject matter is specifically selected, created, implemented, utilized, programmed, and/or designed for the purpose of performing the function. It is also within the scope of the present disclosure that elements, components, and/or other recited subject matter that is recited as being adapted to perform a particular function may additionally or alternatively be described as being configured to perform that function, and vice versa. Similarly, subject matter that is recited as being configured to perform a particular function may additionally or alternatively be described as being operative to perform that function.

As used herein, the phrase, "for example," the phrase, "as an example," and/or simply the term "example," when used with reference to one or more components, features, details, structures, embodiments, and/or methods according to the present disclosure, are intended to convey that the described component, feature, detail, structure, embodiment, and/or method is an illustrative, non-exclusive example of components, features, details, structures, embodiments, and/or methods according to the present disclosure. Thus, the described component, feature, detail, structure, embodiment, and/or method is not intended to be limiting, required, or exclusive/exhaustive; and other components, features, details, structures, embodiments, and/or methods, including structurally and/or functionally similar and/or equivalent components, features, details, structures, embodiments, and/or methods, are also within the scope of the present disclosure.

As used herein, the phrases "at least one of" and "one or more of," in reference to a list of more than one entity, means any one or more of the entities in the list of entities, and is not limited to at least one of each and every entity specifically listed within the list of entities. For example, "at least one of A and B" (or, equivalently, "at least one of A or B," or, equivalently, "at least one of A and/or B") may refer to A alone, B alone, or the combination of A and B.

As used herein, the singular forms "a", "an" and "the" may be intended to include the plural forms as well, unless the context clearly indicates otherwise.

## Claims

1. A wing-to-body join method (100) for an aircraft (12), the method comprising:
(a) calculating (180) a virtual fit between a wing assembly (14) and a body assembly (16) of the aircraft (12); and
b) measuring a 3D profile of a wing root interface surface (22) of the wing assembly (14), measuring a 3D profile of a wing stub interface surface (32) of the body assembly (16), and wherein the calculating (180) the virtual fit includes calculating the virtual fit based upon the 3D profile of the wing root interface surface and the 3D profile of the wing stub interface surface;
c) commanding (114) a wing positioning system (58) to move the wing assembly (14) of the aircraft (12) to a first waypoint (70) along a movement path of the wing assembly (14) between a separated position and a mated position, wherein the mated position is defined by the virtual fit, and wherein the movement path is based upon actual as-built shapes of the wing assembly (14) and body assembly (16), wherein the actual shapes are modeled by performing a 3D scan
(d) after the (c) commanding, iteratively repeating:
(i) determining (152) a first position of the wing assembly (14) by automatically measuring three dimensional locations of a plurality of wing targets (50, 54) on the wing assembly (14),
(ii) calculating (154) a first difference (Δ₁) between the first position and the first waypoint (70), and
(iii) commanding (150) the wing positioning system to move the wing assembly (14) to reduce a magnitude of the first difference (Δ₁), provided that the magnitude of the first difference (Δ₁) is greater than an error tolerance (T₁),
wherein the (d) iteratively repeating includes repeating until the magnitude of the first difference (Δ₁) is less than or equal to the error tolerance (T₁);
(e) after the (d) iteratively repeating, commanding (150) the wing positioning system (58) to move the wing assembly (14) to a second waypoint (70) along the movement path, wherein the second waypoint (70) is closer to the mated position than the first waypoint (70);
(f) after the (c) commanding, iteratively repeating:
(i) determining (152) a second position of the wing assembly (14) by automatically measuring three dimensional locations of the plurality of wing targets (50, 54) on the wing assembly (14),
(ii) calculating (154) a second difference (Δ₁) between the second position and the second waypoint (70), and
(iii) commanding (150) the wing positioning system (58) to move the wing assembly (14) to reduce a magnitude of the second difference (Δ₁), provided that the magnitude of the second difference (Δ₁) is greater than the error tolerance (T₁),
wherein the (f) iteratively repeating includes repeating until the magnitude of the second difference (Δ₁) is less than or equal to the error tolerance (T₁).

2. The method (100) of claim 1, wherein the plurality of wing targets are secondary wing targets (54), wherein the secondary wing targets are in predetermined relative locations with respect to a plurality of primary wing targets (50) that were installed (136) on the wing assembly (14) in known locations with respect to a wing root interface surface (22) of the wing assembly.

3. The method (100) of claim 2, further comprising installing (136) the primary wing targets (50) on the wing assembly (14) at primary wing target locations related to the wing root interface surface (22), wherein each of the primary wing target locations independently is a known location determined by measuring (138) the primary wing target location of a respective primary wing target relative to the wing root interface surface.

4. The method (100) of claim 2 or 3, further comprising installing (140) the secondary wing targets (54) on the wing assembly (14) at secondary wing target locations related to the known locations of the primary wing targets (50).

5. The method (100) of any one of claims 1 to 4, further comprising determining the movement path of the wing assembly (14) relative to the body assembly (16) of the aircraft (12).

6. The method (100) of any one of claims 1 to 5, wherein the movement path includes a series of waypoints (70) between the separated position and the mated position, and wherein spacings between sequential waypoints form a decreasing series of spacings.

7. The method (100) of any one of claims 1 to 6, further comprising forming (182) shims (64) to fit between a wing root (20) of the wing assembly (14) and a wing stub (30) of the body assembly (16) of the aircraft (12), and further comprising installing shims on at least one of the wing root and the wing stub before the (b) iteratively repeating.

8. The method (100) of any one of claims 1 to 7, further comprising a second-phase movement (122) comprising:
(g) after the (f) iteratively repeating, commanding (160) the wing positioning system (58) to move the wing assembly (14) to a third waypoint (70) along the movement path, wherein the third waypoint is closer to the mated position than the second waypoint, wherein the third waypoint is selected to place the wing assembly (14) and the body assembly (16) of the aircraft (12) into a second-phase relative position;
(h) after the (e) commanding, iteratively repeating:
(i) determining (162) a second-phase position of the wing assembly (14) by automatically measuring three dimensional locations of the plurality of wing targets (50, 54) on the wing assembly,
(ii) determining (164) a second-phase position of the body assembly (16) by automatically measuring three dimensional locations of a plurality of body targets (50, 54) on the body assembly (16),
(iii) calculating (166) an actual relative position based on a difference between the second-phase position of the wing assembly (14) and the second-phase position of the body assembly (16),
(iv) calculating (168) a third difference (Δ₂) between the actual relative position and the second-phase relative position, and
(v) commanding (160) the wing positioning system (58) to move the wing assembly (14) to reduce a magnitude of the third difiference(Δ₂), provided that the magnitude of the third difference (Δ₂) is greater than a second-phase error tolerance (T₂),
wherein the (h) iteratively repeating includes repeating until the magnitude of the third difference (Δ₂) is less than or equal to the second-phase error tolerance (T₂).

9. A wing-to-body join method to join a port-side wing assembly (14) and a starboard-side wing assembly (14) to a body assembly (16) of an aircraft (12), the method comprising:
(a) performing the method (100) of any one of claims 1 to 8 with the port-side wing assembly; and
(b) performing the method (100) of any one of claims 1 to 10 with the starboard-side wing assembly;
wherein the (a) performing is at least partially concurrent with the (b) performing.

10. The method (100) of claim 9, wherein the plurality of wing targets are secondary wing targets (54), wherein the secondary wing targets are in predetermined relative locations with respect to a plurality of primary wing targets (50) installed on the wing assembly (14) in known locations with respect to a wing root interface surface (22) of the wing assembly, wherein the plurality of body targets are secondary body targets (54), wherein the secondary body targets are in predetermined relative locations with respect to a plurality of primary body targets (50) installed on the body assembly (16) in known locations with respect to a wing stub interface surface (32) of the body assembly.

11. The method (100) of claim 8 or 10, wherein the method comprises performing a port-side move for a series of port waypoints along a port-side movement path of a port wing assembly (14) to a port side of the body assembly (16), and performing a starboard-side move for a series of starboard waypoints along a starboard-side movement path of a starboard wing assembly (14) to a starboard side of the body assembly.

12. The method (100) of claim 11, wherein the series of port waypoints includes a final port waypoint (76) in which the port wing assembly (14) is mated to the port side of the body assembly (16), and wherein the series of starboard waypoints includes a final starboard waypoint (76) in which the starboard wing assembly (14) is mated to the starboard side of the body assembly.

13. The method (100) of claim 11 or 12, further comprising calculating (180) a virtual port-side fit between the port wing assembly (14) and the port side of the body assembly (16), and calculating (180) a virtual starboard-side fit between the starboard wing assembly (14) and the starboard side of the body assembly, wherein the port waypoint corresponds to the virtual port-side fit and the starboard waypoint corresponds to the virtual starboard-side fit.

## Patentansprüche

1. Flügel-Rumpf-Verbindungsverfahren (100) für ein Luftfahrzeug (12), wobei das Verfahren aufweist:
(a) Berechnen (180) eines virtuellen Fits zwischen einer Flügelanordnung (14) und einer Körperanordnung (16) des Luftfahrzeugs (12); und
b) Messen eines 3D-Profils einer Flügelwurzel-Schnittstellenfläche (22) der Flügelanordnung (14), Messen eines 3D-Profils einer Flügelstummel-Schnittstellenfläche (32) der Körperanordnung (16), und wobei das Berechnen (180) des virtuellen Fits ein Berechnen des virtuellen Fits basierend auf dem 3D-Profil der Flügelwurzel-Schnittstellenfläche und des 3D-Profils der Flügelstummel-Schnittstellenfläche umfasst;
c) Anweisen (114) eines Flügelpositionierungssystems (58) die Flügelanordnung (14) des Luftfahrzeugs (12) zu einem ersten Wegpunkt (70) entlang eines Bewegungswegs der Flügelanordnung (14) zwischen einer getrennten Position und einer Eingriffsposition zu bewegen, wobei die Eingriffsposition durch den virtuellen Fit definiert ist, und wobei der Bewegungsweg auf Formen, wie sie tatsächlich ausgebildet sind, der Flügelanordnung (14) und der Körperanordnung (16) basieren, wobei die tatsächlichen Formen durch ein Durchführen eines 3D-Scans modelliert sind;
(d) nach dem (c) Anweisen iteratives Wiederholen von:
(i) Bestimmen (152) einer ersten Position der Flügelanordnung (14) durch automatisches Messen von dreidimensionalen Orten einer Vielzahl von Flügelzielen (50, 54) an der Flügelanordnung (14),
(ii) Berechnen (154) einer ersten Differenz (Δ₁) zwischen der ersten Position und dem ersten Wegpunkt (70), und
(iii) Anweisen (150) des Flügelpositionierungssystems die Flügelanordnung (14) zu bewegen, um eine Größe der ersten Differenz (Δ₁) zu verringern, wobei vorausgesetzt wird, dass die Größe der ersten Differenz (Δ₁) größer als eine Fehlertoleranz (T₁) ist,
wobei das (d) iterative Wiederholen ein Wiederholen umfasst, bis die Größe der ersten Differenz (Δ₁) kleiner oder gleich der Fehlertoleranz (T₁) ist;
(e) nach dem (d) iterativen Wiederholen Anweisen (150) des Flügelpositionierungssystem (58), die Flügelanordnung (14) zu einem zweiten Wegpunkt (70) entlang des Bewegungswegs zu bewegen, wobei der zweite Wegpunkt (70) sich näher zu der Eingriffsposition als der erste Wegpunkt (70) befindet;
(f) nach dem (c) Anweisen iteratives Wiederholen von:
(i) Bestimmen (152) einer zweiten Position der Flügelanordnung (14) durch automatisches Messen von dreidimensionalen Orten der Vielzahl von Flügelzielen (50, 54) an der Flügelanordnung (14),
(ii) Berechnen (154) einer zweiten Differenz (Δ₁) zwischen der zweiten Position und dem zweiten Wegpunkt (70), und
(iii) Anweisen (150) des Flügelpositionierungssystems (58) die Flügelanordnung (14) zu bewegen, um eine Größe der zweiten Differenz (Δ₁) zu verringern, vorausgesetzt dass die Größe der zweiten Differenz (Δ₁) größer als die Fehlertoleranz (T₁) ist,
wobei das (f) iterative Wiederholen ein Wiederholen umfasst, bis die Größe der zweiten Differenz (Δ₁) kleiner oder gleich der Fehlertoleranz (T₁) ist.

2. Verfahren (100) nach Anspruch 1, wobei die Vielzahl von Flügelzielen sekundäre Flügelziele (54) sind, wobei sich an die sekundären Flügelziele vorbestimmten relativen Orten in Bezug auf eine Vielzahl von primären Flügelzielen (50) befinden, die an der Flügelanordnung (14) an bekannten Orten in Bezug auf eine Flügelwurzel-Schnittstellenfläche (22) der Flügelanordnung installiert wurden (136).

3. Verfahren (100) nach Anspruch 2, das ferner ein Installieren (136) der primären Flügelziele (50) an der Flügelanordnung (14) an primären Flügelzielorten aufweist, die sich auf die Flügelwurzel-Schnittstellenfläche (22) beziehen, wobei jeder der primären Flügelzielorte unabhängig einen bekannten Ort darstellt, der durch ein Messen (138) des primären Flügelzielorts eines jeweiligen primären Flügelziels relativ zu der Flügelwurzel-Schnittstellenfläche bestimmt ist.

4. Verfahren (100) nach Anspruch 2 oder 3, das ferner ein Installieren (140) der sekundären Flügelziele (54) an der Flügelanordnung (14) bei sekundären Flügelzielorten aufweist, die auf die bekannten Orte der primären Flügelzielen (50) bezogen sind.

5. Verfahren (100) nach einem der Ansprüche 1 bis 4, das ferner ein Bestimmen des Bewegungswegs der Flügelanordnung (14) relativ zu der Körperanordnung (16) des Luftfahrzeugs (12) aufweist.

6. Verfahren (100) nach einem der Ansprüche 1 bis 5, wobei der Bewegungsweg eine Serie von Wegpunkten (70) zwischen der getrennten Position und der Eingriffsposition umfasst und wobei Abstände zwischen sequentiellen Wegpunkten eine Serie von Abständen bilden.

7. Verfahren (100) nach einem der Ansprüche 1 bis 6, das ferner ein Ausbilden (182) von Ausgleichselementen (64) aufweist, um zwischen eine Flügelwurzel (20) der Flügelanordnung (14) und einen Flügelstummel (30) der Körperanordnung (16) des Luftfahrzeugs (12) zu passen, und das ferner ein Installieren von Ausgleichselementen an der Flügelwurzel und/oder dem Flügelstummel vor dem (b) iterativen Wiederholen aufweist.

8. Verfahren (100) nach einem der Ansprüche 1 bis 7, das ferner eine Bewegung (122) einer zweiten Phase aufweist, die aufweist:
(g) nach dem (f) iterativen Wiederholen Anweisen (160) des Flügelpositionierungssystems (58), die Flügelanordnung (14) zu einem Wegpunkt (70) entlang des Bewegungswegs zu bewegen, wobei sich der dritte Wegpunkt näher zu der Eingriffsposition befindet als der zweite Wegpunkt, wobei der dritte Wegpunkt ausgewählt ist, um die Flügelanordnung (14) und die Körperanordnung (16) des Luftfahrzeugs (12) in einer Relativposition einer zweiten Phase zu platzieren;
(h) nach dem (e) Anweisen iteratives Wiederholen von:
(i) Bestimmen (162) einer Position einer zweiten Phase der Flügelanordnung (14) durch automatisches Messen von dreidimensionalen Orten der Vielzahl von Flügelzielen (50, 54) an der Flügelanordnung,
(ii) Bestimmen (164) einer Position einer zweiten Phase der Körperanordnung (16) durch automatisches Messen von dreidimensionalen Orten einer Vielzahl von Körperzielen (50, 54) an der Körperanordnung (16),
(iii) Berechnen (166) einer tatsächlichen Relativposition basierend auf einer Differenz zwischen der Position der zweiten Phase der Flügelanordnung (14) und der Position der zweiten Phase der Körperanordnung (16),
(iv) Berechnen (168) einer dritten Differenz (Δ₂) zwischen der tatsächlichen Relativposition und der Relativposition der zweiten Phase, und
(v) Anweisen (160) des Flügelpositionierungssystems (58), um die Flügelanordnung (14) zu bewegen, um eine Größe der dritten Differenz (Δ₂) zu verringern, vorausgesetzt dass die Größe der dritten Differenz (Δ₂) größer als eine Fehlertoleranz einer zweiten Phase (T₂) ist,
wobei das (h) iterative Wiederholen ein Wiederholen umfasst, bis die Größe der dritten Differenz (Δ₂) kleiner oder gleich der Fehlertoleranz der zweiten Phase (T₂) ist.

9. Flügel-Rumpf-Verbindungsverfahren zum Verbinden einer Backbord-Flügelanordnung (14) und einer Steuerbord-Flügelanordnung (14) mit einer Körperanordnung (16) eines Luftfahrzeugs (12), wobei das Verfahren aufweist:
(a) Durchführen des Verfahrens (100) nach einem der Ansprüche 1 bis 8 mit der Backbord-Flügelanordnung; und
(b) Durchführen des Verfahrens (100) nach einem der Ansprüche 1 bis 10 mit der Steuerbord-Flügelanordnung;
wobei das (a) Durchführen zumindest teilweise gleichzeitig mit dem (b) Durchführen erfolgt.

10. Verfahren (100) nach Anspruch 9, wobei die Vielzahl von Flügelzielen sekundäre Flügelziele (54) sind, wobei sich die sekundären Flügelziele an vorbestimmten relativen Orten in Bezug auf eine Vielzahl von primären Flügelzielen (50) befinden, die an der Flügelanordnung (14) an bekannten Orten in Bezug auf eine Flügelwurzel-Schnittstellenfläche (22) der Flügelanordnung installiert sind, wobei die Vielzahl von Körperzielen sekundäre Körperziele (54) darstellen, wobei sich die sekundären Körperziele an vorbestimmten relativen Orten in Bezug auf eine Vielzahl von primären Körperzielen (50) befinden, die an der Körperanordnung (16) an bekannten Orten in Bezug auf eine Flügelstummel-Schnittstellenfläche (32) der Körperanordnung installiert sind.

11. Verfahren (100) nach Anspruch 8 oder 10, wobei das Verfahren eine Backbordbewegung für eine Reihe von Backbord-Wegpunkten entlang eines Backbord-Bewegungswegs einer Backbord-Flügelanordnung (14) auf eine Backbordseite der Körperanordnung (16) und ein Durchführen einer Steuerbordbewegung für eine Reihe von Steuerbord-Wegpunkten entlang eines Steuerbord-Bewegungswegs einer Steuerbord-Flügelanordnung (14) auf eine Steuerbordseite der Körperanordnung aufweist.

12. Verfahren (100) nach Anspruch 11, wobei die Reihe von Backbord-Wegpunkten einen finalen Backbord-Wegpunkt (76) umfasst, in welchem die Backbord-Flügelanordnung (14) sich im Eingriff mit der Backbordseite der Körperanordnung (16) befindet, und wobei die Reihe von Steuerbord-Wegpunkten einen finalen Steuerbord-Wegpunkt (76) umfasst, in welchem sich die Steuerbord-Flügelanordnung (14) in Eingriff mit der Steuerbordseite der Körperanordnung befindet.

13. Verfahren (100) nach Anspruch 11 oder 12, das ferner ein Berechnen (180) eines virtuellen Backbord-Fits entlang der Backbord-Flügelanordnung (14) und der Backbordseite der Körperanordnung (16) und ein Berechnen (180) eines virtuellen Steuerbord-Fits zwischen der Steuerbord-Flügelanordnung (14) und der Steuerbordseite der Körperanordnung aufweist, wobei der Backbord-Wegpunkt dem virtuellen Backbord-Fit entspricht und der Steuerbord-Wegpunkt dem virtuellen Steuerbord-Fit entspricht.

## Revendications

1. Procédé de jonction aile-fuselage (100) pour un aéronef (12), le procédé comprenant :
(a) le calcul (180) d'un ajustement virtuel entre un ensemble aile (14) et un ensemble fuselage (16) de l'aéronef (12) ; et
(b) la mesure d'un profil 3D d'une surface d'interface d'emplanture d'aile (22) de l'ensemble aile (14), la mesure d'un profil 3D d'une surface d'interface de bout d'aile (32) de l'ensemble fuselage (16), et le calcul (180) de l'ajustement virtuel comprenant le calcul de l'ajustement virtuel sur la base du profil 3D de la surface d'interface d'emplanture d'aile et du profil 3D de la surface d'interface de bout d'aile ;
(c) la commande (114) à un système de positionnement d'aile (58) de déplacer l'ensemble aile (14) de l'aéronef (12) jusqu'à un premier point de cheminement (70) le long d'une trajectoire de déplacement de l'ensemble aile (14) entre une position séparée et une position d'accouplement, la position d'accouplement étant définie par l'ajustement virtuel, et la trajectoire de déplacement étant basée sur les formes réelles telles que construites de l'ensemble aile (14) et de l'ensemble fuselage (16), les formes réelles étant modelées par réalisation d'un balayage 3D ;
(d) après la commande (c), la répétition de manière itérative de :
(i) la détermination (152) d'une première position de l'ensemble aile (14) en mesurant automatiquement les emplacements tridimensionnels d'une pluralité de cibles d'aile (50, 54) sur l'ensemble aile (14),
(ii) le calcul (154) d'une première différence (Δ₁) entre la première position et le premier point de cheminement (70), et
(iii) la commande (150) au système de positionnement d'aile de déplacer l'ensemble aile (14) pour réduire une amplitude de la première différence (Δ₁), dès lors que l'amplitude de la première différence (Δ₁) est supérieure à une tolérance d'erreur (T₁),
la répétition de manière itérative (d) comprenant la répétition jusqu'à ce que l'amplitude de la première différence (Δ₁) soit inférieure ou égale à la tolérance d'erreur (T₁) ;
(e) après la répétition de manière itérative (d), la commande (150) au système de positionnement d'aile (58) de déplacer l'ensemble aile (14) jusqu'à un deuxième point de cheminement (70) le long de la trajectoire de déplacement, le deuxième point de cheminement (70) étant plus proche de la position d'accouplement que le premier point de cheminement (70) ;
(f) après la commande (c), la répétition de manière itérative de :
(i) la détermination (152) d'une deuxième position de l'ensemble aile (14) en mesurant automatiquement les emplacements tridimensionnels de la pluralité de cibles d'aile (50, 54) sur l'ensemble aile (14),
(ii) le calcul (154) d'une deuxième différence (Δ₁) entre la deuxième position et le deuxième point de cheminement (70), et
(iii) la commande (150) au système de positionnement d'aile (58) de déplacer l'ensemble aile (14) pour réduire une amplitude de la deuxième différence (Δ₁), dès lors que l'amplitude de la deuxième différence (Δ₁) est supérieure à la tolérance d'erreur (T₁),
la répétition de manière itérative (f) comprenant la répétition jusqu'à ce que l'amplitude de la deuxième différence (Δ₁) soit inférieure ou égale à la tolérance d'erreur (T₁).

2. Procédé (100) selon la revendication 1, la pluralité de cibles d'aile étant des cibles d'aile secondaires (54), les cibles d'aile secondaires étant à des emplacements relatifs prédéterminés par rapport à une pluralité de cibles d'aile principales (50) qui étaient installées (136) sur l'ensemble aile (14) à des emplacements connus par rapport à une surface d'interface d'emplanture d'aile (22) de l'ensemble aile.

3. Procédé (100) selon la revendication 2, comprenant en outre l'installation (136) des cibles d'aile principales (50) sur l'ensemble aile (14) à des emplacements de cibles d'aile principales liés à la surface d'interface d'emplanture d'aile (22), chacun des emplacements de cibles d'aile principales étant indépendamment un emplacement connu déterminé par mesure (138) de l'emplacement de cible d'aile principale d'une cible d'aile principale respective par rapport à la surface d'interface d'emplanture d'aile.

4. Procédé (100) selon la revendication 2 ou 3, comprenant en outre l'installation (140) des cibles d'aile secondaires (54) sur l'ensemble aile (14) à des emplacements de cibles d'aile secondaires liés aux emplacements connus des cibles d'aile principales (50).

5. Procédé (100) selon l'une quelconque des revendications 1 à 4, comprenant en outre la détermination de la trajectoire de déplacement de l'ensemble aile (14) par rapport à l'ensemble fuselage (16) de l'aéronef (12).

6. Procédé (100) selon l'une quelconque des revendications 1 à 5, la trajectoire de déplacement comprenant une série de points de cheminement (70) entre la position séparée et la position d'accouplement, et des espacements entre des points de cheminement séquentiels formant une série décroissante d'espacements.

7. Procédé (100) selon l'une quelconque des revendications 1 à 6, comprenant en outre la formation (182) de cales (64) destinées à s'ajuster entre une emplanture d'aile (20) de l'ensemble aile (14) et un bout d'aile (30) de l'ensemble fuselage (16) de l'aéronef (12), et comprenant en outre l'installation de cales sur au moins l'un de l'emplanture d'aile et du bout d'aile avant la répétition de manière itérative (b).

8. Procédé (100) selon l'une quelconque des revendications 1 à 7, comprenant en outre un mouvement de seconde phase (122) comprenant :
(g) après la répétition de manière itérative (f), la commande (160) au système de positionnement d'aile (58) de déplacer l'ensemble aile (14) jusqu'à un troisième point de cheminement (70) le long de la trajectoire de déplacement, le troisième point de cheminement étant plus proche de la position d'accouplement que le deuxième point de cheminement, le troisième point de cheminement étant sélectionné pour placer l'ensemble aile (14) et l'ensemble fuselage (16) de l'aéronef (12) dans une position relative de seconde phase ;
(h) après la commande (e), la répétition de manière itérative de :
(i) la détermination (162) d'une position de seconde phase de l'ensemble aile (14) en mesurant automatiquement les emplacements tridimensionnels de la pluralité de cibles d'aile (50, 54) sur l'ensemble aile,
(ii) la détermination (164) d'une position de seconde phase de l'ensemble fuselage (16) en mesurant automatiquement les emplacements tridimensionnels d'une pluralité de cibles de fuselage (50, 54) sur l'ensemble fuselage (16),
(iii) le calcul (166) d'une position relative réelle sur la base d'une différence entre la position de seconde phase de l'ensemble aile (14) et la position de seconde phase de l'ensemble fuselage (16),
(iv) le calcul (168) d'une troisième différence (Δ₂) entre la position relative réelle et la position relative de seconde phase, et
(v) la commande (160) au système de positionnement d'aile (58) de déplacer l'ensemble aile (14) pour réduire l'amplitude de la troisième différence (Δ₂), dès lors que l'amplitude de la troisième différence (Δ₂) est supérieure à une tolérance d'erreur (T₂) de seconde phase,
la répétition de manière itérative (h) comprenant la répétition jusqu'à ce que l'amplitude de la troisième différence (Δ₂) soit inférieure ou égale à la tolérance d'erreur de seconde phase (T₂).

9. Procédé de jonction aile-fuselage pour joindre un ensemble aile côté bâbord (14) et un ensemble aile côté tribord (14) à un ensemble fuselage (16) d'un aéronef (12), le procédé comprenant :
(a) la réalisation du procédé (100) selon l'une quelconque des revendications 1 à 8 avec l'ensemble aile côté bâbord ; et
(b) la réalisation du procédé (100) selon l'une quelconque des revendications 1 à 10 avec l'ensemble aile côté tribord ;
la réalisation (a) étant au moins partiellement simultanée avec la réalisation (b).

10. Procédé (100) selon la revendication 9, la pluralité de cibles d'aile étant des cibles d'aile secondaires (54), les cibles d'aile secondaires étant à des emplacements relatifs prédéterminés par rapport à une pluralité de cibles d'aile principales (50) installées sur l'ensemble aile (14) à des emplacements connus par rapport à une surface d'interface d'emplanture d'aile (22) de l'ensemble aile, la pluralité de cibles de fuselage étant des cibles de fuselage secondaires (54), les cibles de fuselage secondaires étant à des emplacements relatifs prédéterminés par rapport à une pluralité de cibles de fuselage principales (50) installées sur l'ensemble fuselage (16) à des emplacements connus par rapport à une surface d'interface de bout d'aile (32) de l'ensemble fuselage.

11. Procédé (100) selon la revendication 8 ou 10, le procédé comprenant la réalisation d'un déplacement côté bâbord pour une série de points de cheminement bâbord le long d'une trajectoire de déplacement côté bâbord d'un ensemble aile bâbord (14) jusqu'à un côté bâbord de l'ensemble fuselage (16) et la réalisation d'un déplacement côté tribord pour une série de points de cheminement tribord le long d'une trajectoire de déplacement côté tribord d'un ensemble aile tribord (14) jusqu'à un côté tribord de l'ensemble fuselage.

12. Procédé (100) selon la revendication 11, la série de points de cheminement bâbord comprenant un point de cheminement bâbord final (76) dans lequel l'ensemble aile bâbord (14) est accouplé au côté bâbord de l'ensemble fuselage (16), et la série de points de cheminement tribord comprenant un point de cheminement tribord final (76) dans lequel l'ensemble aile tribord (14) est accouplé au côté tribord de l'ensemble fuselage.

13. Procédé (100) selon la revendication 11 ou 12, comprenant en outre le calcul (180) d'un ajustement virtuel côté bâbord entre l'ensemble aile bâbord (14) et le côté bâbord de l'ensemble fuselage (16), et le calcul (180) d'un ajustement virtuel côté tribord entre l'ensemble aile tribord (14) et le côté tribord de l'ensemble fuselage, le point de cheminement bâbord correspondant à l'ajustement virtuel côté bâbord et le point de cheminement tribord correspondant à l'ajustement virtuel côté tribord.
